# EUROPEAN PATENT APPLICATION

(11) **EP 2 325 872 A1**
(43) Date of publication of application: **25.05.2011**
(21) Application number: 09809894.0
(22) Date of filing: 25.08.2009
(51) Int. Cl.: H01L 21/331, H01L 21/329, H01L 29/73, H01L 29/80

(54) **BIPOLAR SEMICONDUCTOR DEVICE AND METHOD FOR MANUFACTURING SAME**

(30) Priority: 26.08.2008 JP 2008217391
(71) Applicant: Honda Motor Co., Ltd., Minato-ku Tokyo 107-8556 (JP); Shindengen Electric Manufacturing Co., Ltd., Tokyo 100-0004 (JP)
(72) Inventor: NEGORO, Yuki, Wako-shi Saitama 351-0193 (JP); HORIUCHI, Akihiko, Wako-shi Saitama 351-0193 (JP); IWANAGA, Kensuke, Wako-shi Saitama 351-0193 (JP); YOKOYAMA, Seiichi, Wako-shi Saitama 351-0193 (JP); HASHIMOTO, Hideki, Wako-shi Saitama 351-0193 (JP); NONAKA, Kenichi, Wako-shi Saitama 351-0193 (JP); MAEYAMA, Yusuke, Hanno-shi Saitama 357-8585 (JP); SATO, Masashi, Hanno-shi Saitama 357-8585 (JP); SHIMIZU, Masaaki, Hanno-shi Saitama 357-8585 (JP)
(74) Representative: Beder, Jens
(86) International application number: PCT/JP2009/064776
(87) International publication number: WO 2010/024243

(57) **Abstract**

Disclosed is a bipolar semiconductor device which is capable of reducing the surface state density of a bipolar transistor and increasing the current gain of the transistor, thereby improving the transistor performance. A bipolar semiconductor device (100) has a surface protective film (30) on the surface of a semiconductor element. The surface protective film is composed of a thermal oxide film (31) formed on the surface of the semiconductor element, and a deposited oxide film (32) formed on the thermal oxide film. The deposited oxide film contains at least one of hydrogen element and nitrogen element in an amount of not less than 10¹⁸ cm⁻³.

## Description

### TECHNICAL FIELD

The present invention relates to a bipolar semiconductor device and a method for manufacturing the same. More particularly, the present invention relates to a bipolar semiconductor device that comprises a semiconductor element achieving a high current gain by removing surface states formed at the surface thereof and a method for manufacturing such a bipolar semiconductor device.

### BACKGROUND ART

Silicon carbide (hereinafter, referred to as "SiC") has band gap energy larger than that of silicon widely used in semiconductor devices. Therefore, semiconductor devices using SiC are suitable for high-voltage, high-power, and high-temperature operation, and are expected to be used as power devices and the like. The structure of SiC power devices now under research and development can be roughly classified into two types: a "MOS" structure and a "junction" structure.

Examples of a junction SiC power semiconductor device include static induction transistors (SITs), junction field-effect transistors (JFETs), and bipolar junction transistors (BJTs).

As an example of a conventional BJT, one having a structure described in, for example, Non-Patent Document 1 can be mentioned. The BJT is formed by laminating, on a low-resistance n⁺-type 8°-off 4H-SiC(0001) substrate, an n--type high-resistance region, a p-type base region, and an n⁺-type emitter region in this order from the bottom. The emitter region is composed of a plurality of elongated regions. Electrodes are formed on the emitter region, the base region, and the collector region to make electrical connections to the outside.

Fig. 7 is a sectional view showing the structure of the BJT disclosed in Non-Patent Document 1. As shown in Fig. 7, a BJT 500 includes a collector region 501 composed of an n-type low-resistance layer, an n-type high-resistance region 502, a p-type base region 503, an n-type low-resistance emitter region 504, and a p-type low-resistance base contact region 505 formed so as to surround the emitter region. A collector electrode 506 is joined to the outside of the collector region 501, a base electrode 507 is joined to the outside of the base region 503 (base contact region 505), and emitter electrodes 508 are joined to the outside of the emitter region 504 to make electrical connections. Further, the entire exposed surface of the BJT 500 except for the electrodes is covered with a surface protective film 509.

Atoms with dangling bonds are present at a high density on the SiC surface of a SiC semiconductor device, and therefore surface states are formed. Electrons and holes generated inside a junction SiC semiconductor device are actively recombined via the surface states, and therefore it is necessary to prevent recombination of electrons and holes to increase the current gain of the semiconductor device. The probability of recombination of electrons and holes can be reduced by previously removing the surface states.

In the case of conventional junction SiC semiconductor devices such as unipolar MOSFETs described in Patent Documents 1 and 2, an attempt has been made to remove the surface states by forming an oxide film.

Patent Document 1 discloses a laminated structure composed of a metal, an oxide film, and a SiC semiconductor. The laminated structure is a MOS structure obtained by forming an oxide film on the surface of a SiC semiconductor and then further forming a metal on the oxide film. The electrical characteristics, such as a current-voltage curve, of a MOS structure depend on manufacturing conditions. Therefore, Patent Document 1 describes that the thickness of the oxide film is specified to eliminate the influence of the surface potential of the MOS structure.

Patent Document 2 relates to a method for manufacturing a semiconductor device, which aims to reduce the interface state density of gate region of a SiC semiconductor device. The semiconductor device is a unipolar MOS device having a gate insulating film. The method disclosed in Patent Document 2 makes it possible to reduce the density of interface states formed near the conduction band bottom and is therefore effective for electrons, thereby reducing the resistance of a channel region.

### PRIOR ART DOCUMENTS

### Patent Documents

Patent Document 1: Japanese Patent No. 3855019
Patent Document 2: Japanese Patent No. 3443589

### Non-Patent Document

Non-Patent Document 1: J. Zhang et al, "High Power (500V- 70A) and High Gain (44-47) 4H-SiC Bipolar Junction Transistors", Materials Science Forum Vols. 457-460 (2004), pp. 1149-1152.

### SUMMARY OF INVENTION

### Technical Problem

In order to efficiently operate a current-driven (current-controlled) transistor such as a BJT or a bipolar mode SIT, it is preferred that a larger principal current is controlled by a smaller base current (in the case of a SIT, by a smaller gate current). Therefore, a current gain (= principal current/base (gate) current) is an important parameter. It is to be noted that a current flowing between main electrodes is referred to as a "principal current" and a base or gate current flowing through a control electrode is referred to as a "control current".

A recombination state at a semiconductor surface is a factor that reduces the current gain. A large number of surface states caused by dangling bonds are present at a semiconductor surface. In the case of silicon, a silicon/oxide film interface with a low surface-state density that does not affect device characteristics can be formed by thermal oxidation. On the other hand, in the case of SiC, it is currently impossible to sufficiently reduce a surface-state density by thermal oxidation or by a combination of thermal oxidation and heat treatment performed after the thermal oxidation. Therefore, a bipolar SiC semiconductor device involves a problem that recombination of electrons and holes at its semiconductor surface cannot be inhibited and therefore it is difficult to achieve a sufficiently high current gain.

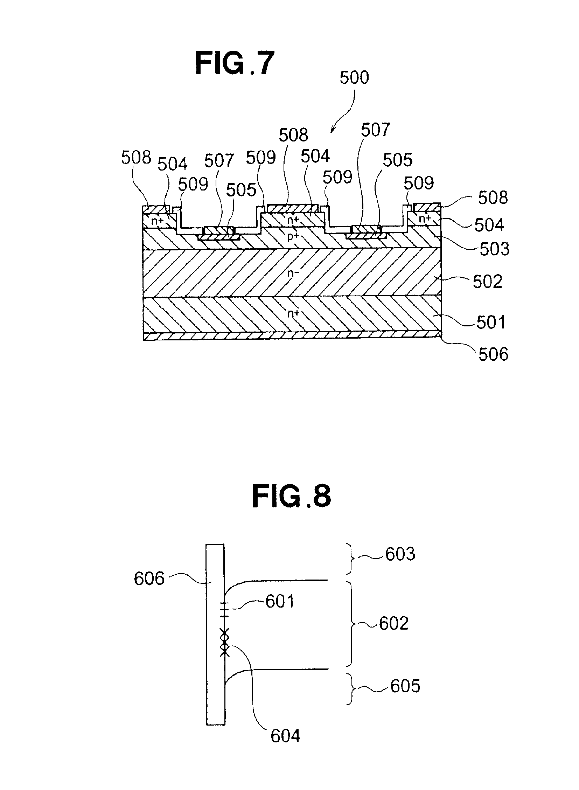

As for conventional techniques for reducing the surface states of a SiC semiconductor device, there are many techniques proposed from the viewpoint of improving the performance of a MOS transistor. However, there are not many conventional techniques proposed from the viewpoint of improving the current gain of a bipolar transistor such as a BJT. As shown in Fig. 8, surface states (interface states) 601 that affect improvement in the performance of a MOS transistor are present in an energy band close to a conduction band 603 in a band gap 602. Techniques for reducing such surface states are known.

On the other hand, surface states that affect improvement in the current gain of a bipolar transistor (n-type SiC) are present near a center 604 of the band gap 602 (also referred to as a "mid gap"). Therefore, it is difficult to reduce the density of surface states present near the mid gap 604 even when a technique capable of improving the performance of a MOS transistor such as one disclosed in the above-mentioned Patent Document 1 or 2 is used, and therefore it is difficult to improve the performance of a bipolar transistor. In Fig. 8, the reference numeral 605 denotes a valence band and the reference numeral 606 denotes the band gap of an insulator.

### Solution to Problem

In view of the above problem, it is an object of the present invention to provide a bipolar semiconductor device that comprises a bipolar transistor with improved transistor performance by reducing the surface-state density of the bipolar transistor to increase the current gain of the bipolar transistor and a method for manufacturing such a bipolar semiconductor device.

One aspect of the present invention provides a bipolar semiconductor device comprising: a semiconductor element having a surface; and a surface protective film provided on the surface of the semiconductor element, wherein the surface protective film has a laminated structure composed of a thermal oxide film formed on the surface of the semiconductor element and a deposited oxide film formed on the thermal oxide film, and wherein the deposited oxide film contains at least one of a hydrogen element and a nitrogen element in an amount of 10¹⁸ cm⁻³ or more.

Another aspect of the present invention provides a bipolar semiconductor device comprising: a semiconductor element having a surface; and a surface protective film provided on the surface of the semiconductor element, wherein the surface protective film has a laminated structure composed of a thermal oxide film formed on the surface of the semiconductor element, a deposited oxide film formed on the thermal oxide film, and a deposited nitride film formed on the thermal oxide film, and wherein the deposited oxide film contains at least one of a hydrogen element and a nitrogen element in an amount of 10¹⁹ cm⁻³ or more.

It is preferred that the deposited oxide film has a film thickness of 150 nm or more.

Further, it is also preferred that the semiconductor element is a silicon carbide semiconductor element and includes a collector region composed of an n-type low-resistance layer formed on one of surfaces of a silicon carbide semiconductor crystal, an emitter region composed of an n-type low-resistance layer formed on another surface of the silicon carbide semiconductor crystal, a p-type base contact region formed around the emitter region, and a base region and an n-type high-resistance layer provided between the emitter region and the collector region, and wherein the surface protective film is formed on the surface of the silicon carbide semiconductor element in the base region and the emitter region.

Further, it is also preferred that the semiconductor element is a silicon carbide semiconductor element and includes a drain region composed of an n-type low-resistance layer formed on one of surfaces of a silicon carbide semiconductor crystal, a source region composed of an n-type low-resistance layer formed on another surface of the silicon carbide semiconductor crystal, a p-type gate region formed around the source region, and an n-type high-resistance layer provided between the source region and the drain region, and wherein the surface protective film is formed on the surface of the silicon carbide semiconductor element in the gate region and the source region.

Further, it is also preferred that the semiconductor element is a silicon carbide semiconductor element and includes a cathode region composed of an n-type resistance layer formed on one of surfaces of a silicon carbide semiconductor crystal and an anode region composed of a p-type resistance layer formed on another surface of the silicon carbide semiconductor crystal, and wherein an anode electrode is formed on the anode region and the surface protective film is formed on the surface of the silicon carbide semiconductor element except for the anode electrode.

Further, it is also preferred that the bipolar semiconductor device further comprises a p-type channel dope layer provided in the high-resistance layer, the p-type channel dope layer being connected to the gate region.

Yet another aspect of the present invention provides a method for manufacturing a bipolar semiconductor device comprising a silicon carbide semiconductor element having a surface and a surface protective film provided on the surface of the silicon carbide semiconductor element, the method comprising the steps of: forming a thermal oxide film on the surface of the silicon carbide semiconductor element; and forming a deposited oxide film on the thermal oxide film, wherein the surface protective film is composed of the thermal oxide film and the deposited oxide film, and wherein the deposited oxide film contains at least one of a hydrogen element and a nitrogen element in an amount of 10¹⁸ cm⁻³ or more.

Yet another aspect of the present invention provides a method for manufacturing a bipolar semiconductor device comprising a silicon carbide semiconductor element having a surface and a surface protective film provided on the surface of the silicon carbide semiconductor element, the method comprising the steps of: forming a thermal oxide film on the surface of the silicon carbide semiconductor element; forming a deposited oxide film on the thermal oxide film; and forming a deposited nitride film on the deposited oxide film, wherein the surface protective film is composed of the thermal oxide film, the deposited oxide film, and the deposited nitride film, and wherein the deposited oxide film contains at least one of a hydrogen element and a nitrogen element in an amount of 10¹⁹ cm⁻³ or more.

In the method for manufacturing a bipolar semiconductor device according to the present invention, the deposited oxide film preferably has a film thickness of 150 nm or more.

### Advantageous Effects of Invention

The bipolar semiconductor device according to the present invention has a surface protective film (surface passivation film) formed on the exposed surface of its silicon carbide (SiC) semiconductor element, the surface protective film has a laminated structure composed of a thermal oxide film and a deposited oxide film or a laminated structure composed of a thermal oxide film, a deposited oxide film, and a deposited nitride film, and the deposited oxide film contains a hydrogen element and a nitrogen element in predetermined amounts. This makes it possible to reduce surface states (mid-gap states) formed in the silicon carbide semiconductor element, thereby preventing recombination of electrons and holes. This further makes it possible to increase the current gain of the bipolar SiC semiconductor device. When the bipolar SiC semiconductor device according to the present invention is applied to a diode, a leak current (recombination current in forward operation, generated current in backward operation) can be suppressed.

The method for manufacturing a bipolar semiconductor device according to the present invention makes it possible to manufacture a bipolar SiC semiconductor device having such effects as described above by a simple process at low cost.

### BRIEF DESCRIPTION OF DRAWINGS

Fig. 1 is a flow chart of a method for manufacturing a bipolar semiconductor device according to a first embodiment of the present invention.
Figs. 2(a) to 2(g) are sectional views showing a device structure corresponding to the steps of the method for manufacturing a bipolar semiconductor device according to the first embodiment of the present invention, respectively.
Fig. 3 is an enlarged partial longitudinal sectional view showing the structure of a bipolar semiconductor device (BJT) according to the first embodiment of the present invention.
Fig. 4 is an enlarged partial sectional view similar to Fig. 3 showing the structure of a bipolar semiconductor device (BJT) according to a second embodiment of the present invention.
Fig. 5 is an enlarged sectional view showing the structure of a bipolar semiconductor device (pn diode) according to a third embodiment of the present invention.
Fig. 6 is an enlarged sectional view showing the structure of a bipolar semiconductor device (pn diode) according to a fourth embodiment of the present invention.
Fig. 7 is a sectional view of a conventional bipolar semiconductor device (BJT).
Fig. 8 is an energy band diagram for explaining mid-gap states that cause surface states in a bipolar semiconductor device.

### MODES FOR CARRYING OUT THE INVENTION

Hereinbelow, certain preferred embodiments of the present invention will be described based on the accompanying drawings.

### First Embodiment

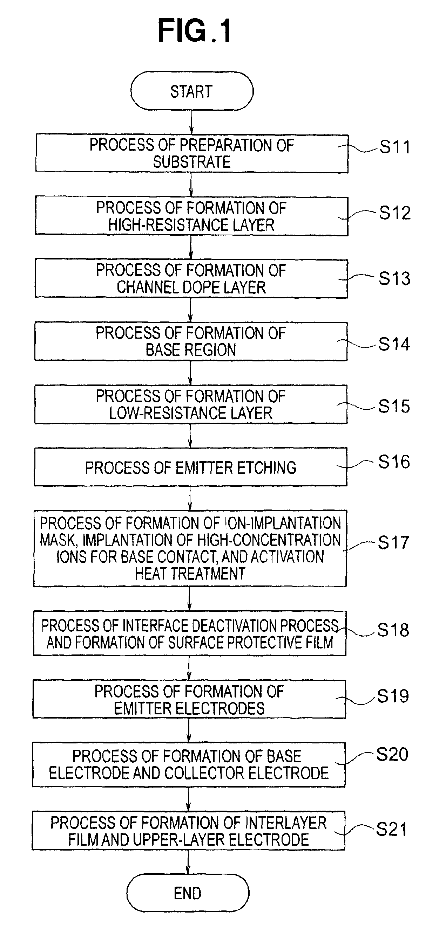

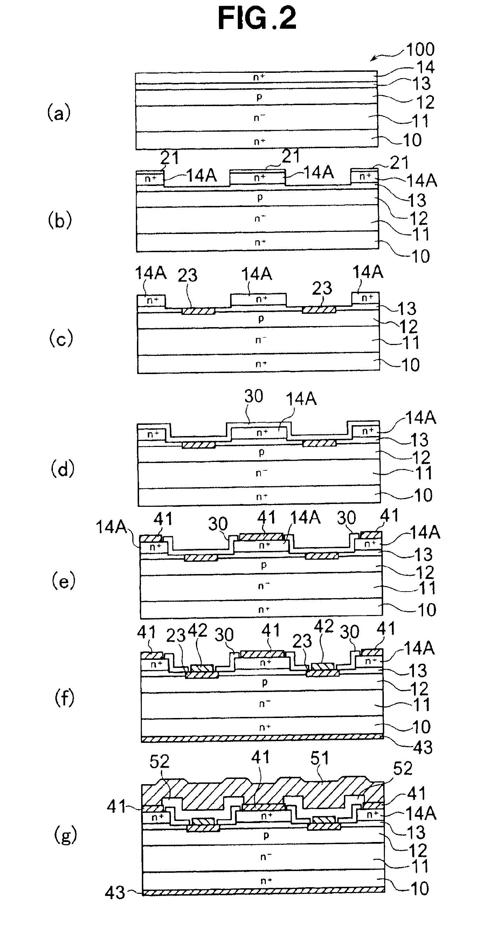

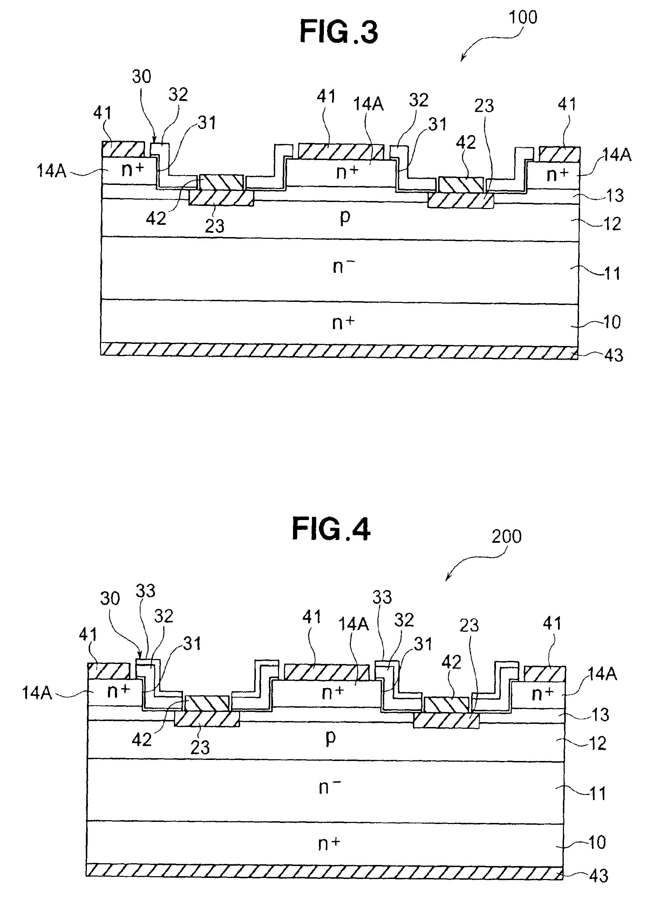

A first embodiment of a bipolar semiconductor device according to the present invention will be described with reference to Figs. 1 to 3. This bipolar semiconductor device is an example of a BJT. A method for manufacturing the BJT and the structure of the BJT will be described with reference to Figs. 1 to 3. Fig. 1 is a flow chart showing the steps of the manufacturing method, Figs. 2(a) to 2(g) are sectional views showing the steps of manufacturing a BJT 100, and Fig. 3 is an enlarged view of Fig. 2(f) showing the laminated structure of a surface protective film in detail.

The BJT manufacturing method comprises the following processes (1) to (11) (steps S11 to S21). As shown in Fig. 1, the processes (1) to (11) are carried out in the steps S11 to S21, respectively.
(1) Process of preparation of n⁺-type low-resistance substrate (crystal) for forming SiC semiconductor element (step S11)
(2) Process of formation of n--type high-resistance layer (step S12)
(3) Process of formation of p-type channel dope layer (step S13)
(4) Process of formation of base region (step S14)
(5) Process of formation of n⁺-type low-resistance layer (step S15)
(6) Process of emitter etching (step S16)
(7) Process of formation of ion implantation mask, implantation of high-concentration ions for base contact, and activation heat treatment (step S17)
(8) Process of interface deactivation treatment and formation of surface protective film (step S18)
(9) Process of formation of emitter electrodes (step S19)
(10) Process of formation of base electrode and collector electrode (step S20)
(11) Process of formation of interlayer film and upper-layer electrode (step S21)

A laminated structure shown in Fig. 2(a) is formed by carrying out the above steps S11 to S15 in order.

In the substrate preparation process (step S11), an n⁺-type low-resistance substrate (crystal) 10 for forming a SiC semiconductor element is prepared. As the substrate 10, "4H-SiC(0001) 8° off" is used. The substrate 10 is located on the lower side of the BJT 100 shown in the drawings and serves as a collector region composed of an n-type low-resistance layer.

In the process of formation of an n-type high-resistance layer (step S12), a high-resistance layer 11 doped with nitrogen to a concentration of 1 × 10¹⁶ cm⁻³ as an impurity is grown to a thickness of 10 µm on the substrate 10 for forming a SiC semiconductor element by epitaxial growth.

In the process of formation of a channel dope layer (step S13), a channel dope region 12 doped with aluminum (Al) to a concentration of 4 × 10¹⁷ to 2 × 10¹⁸ cm⁻³ as an impurity is grown to a thickness of 0.1 to 0.5 µm on the high-resistance layer 11 by epitaxial growth.

In the process of formation of a base region (step S14), a p-type base region 13 is further similarly grown on the channel dope layer 12 by epitaxial growth.

In the process of formation of a low-resistance layer (step S15), an n-type low-resistance layer 14 doped with nitrogen to a concentration of 1 × 10¹⁹ to 5 × 10¹⁹ cm⁻³ as an impurity is grown to a thickness of 0.5 to 2.0 µm on the base region 13 by epitaxial growth. This low-resistance layer 14 will be etched later to form an emitter region.

In the next emitter-etching process (step S16), a silicon dioxide film 21 is deposited on the upper surface of the laminated structure shown in Fig. 2(a) by CVD, and is then subjected to photolithography, and is then further dry-etched by RIE to form an etching mask. Then, the low-resistance layer 14 is subjected to SiC etching by RIE using the etching mask made of the silicon dioxide film 21 to form an emitter region 14A using the low-resistance layer 14. The RIE for SiC etching is performed in an atmosphere of, for example, HBr gas, Cl₂ gas, or H₂/O₂ gas, and the etching depth is 0.5 to 2.1 µm. The thus obtained structure is shown in Fig. 2(b).

In the process of formation of an ion implantation mask, implantation of high-concentration ions for base contact, and activation heat treatment (step S17), the following treatments are performed, respectively.

### (1) Ion Implantation Mask

A mask is formed to have openings to expose the surface of the base region 13 where a base contact region 23 is to be formed. The mask is formed by depositing a silicon dioxide film by CVD, performing photolithography, and dry-etching the silicon dioxide film by RIE. It is to be noted that the mask is not shown in Fig. 2(c). In Fig. 2(c), only the resulting base contact region 23 is shown.

### (2) Implantation of High-Concentration Ions for Base Contact

In the process of formation of the base contact region 23, ion implantation is performed using the above-mentioned ion implantation mask to form the base contact region 23. For example, aluminum (Al) ions are implanted. The implantation depth is, for example, 0.2 µm. The amount of ions to be implanted is 1 × 10¹⁸ to 1 × 10¹⁹ cm⁻³, and ions are implanted at a maximum energy of about 400 KeV in multiple stages.

### (3) Activation Heat Treatment

In the process of activation of an ion-implanted layer, heat treatment is performed after ion implantation to electrically activate implanted ions in the semiconductor and to eliminate crystal defects induced by ion implantation. This activation heat treatment activates both implanted ions in the base contact region 23 and implanted ions in a recombination-inhibiting region 22 at the same time. More specifically, the activation heat treatment is performed using, for example, a high-frequency heat treatment furnace at a high temperature of about 1700 to 1900°C for about 10 to 30 minutes in an atmosphere of, for example, argon (Ar) gas or under vacuum.

The process of interface deactivation treatment and formation of surface protective film (step S18) will be described below. Fig. 2(d) corresponds to step S18 that is characteristic of the present invention. In Fig. 2(d), the reference numeral 30 denotes a surface protective film. The surface protective film 30 is shown in detail in Fig. 3 that is an enlarged view of Fig. 2(f) described later. In the process of interface deactivation treatment and formation of surface protective film (step S18), the following treatments are performed, respectively.

### (1) Interface Deactivation Treatment

Deactivation treatment is performed on the uppermost SiC surface of the BJT 100 shown in Fig. 2(c). In the deactivation treatment, the SiC surface is first subjected to sacrificial oxidation and then to pyrogenic oxidation. The sacrificial oxidation is performed, for example, at a temperature of 1100°C for 20 hours to form a sacrificial oxide film on the SiC surface. Then, the sacrificial oxide film is removed. Then, the pyrogenic oxidation is performed, for example, at a temperature of 1000°C for 1 to 4 hours. Then, heat treatment (POA: Post Oxidation Anneal) is performed using H₂ (hydrogen gas), for example, at a temperature of 1000°C for 30 minutes. POA is heat treatment performed to reduce the impurity level of a SiC/oxide film interface. In this way, as shown in Fig. 3, a thermal oxide film 31 having a thickness of, for example, about 100 Å is formed on the SiC surface of the BJT.

### (2) Surface Protective Film Formation

As shown in Fig. 3, a PSG (Phospho-Silicate-Glass) film (P(phosphorus)-containing passivation film) is deposited on the thermal oxide film 31 to form a deposited oxide film 32 having a thickness of, for example, about 5000 Å. Then, annealing treatment (heat treatment) is performed using NH₃ (ammonia gas). The NH₃ annealing treatment is performed, for example, at a temperature of 740°C and a pressure of 1 mbar for 50 to 100 minutes. The gas atmosphere during the NH₃ annealing treatment is a 1:1.2 mixed gas of N₂ (nitrogen gas) and NH₃ (ammonia gas).

In this way, the surface protective film 30 (shown in Figs. 2(d), 2(e), 2(f), and 2(g)) having a laminated structure composed of the thermal oxide film 31 and the deposited oxide film 32 is formed on the exposed SiC surface of the BJT 100. More specifically, as shown in Fig. 3, the thermal oxide film 31 and the deposited oxide film 32 are formed on the SiC surface extending from the emitter region 14A except for emitter electrodes 41 to the base contact region 23 except for a base electrode 42. By forming these films, it is possible to remove surface states formed at the SiC surface region.

The deposited oxide film 32 preferably contains at least one of a hydrogen element and a nitrogen element in an amount of 10¹⁸ cm⁻³ or more, more preferably in an amount of 10¹⁸ to 10²³ cm⁻³. If the amount of each of a hydrogen element and a nitrogen element is less than 10¹⁸ cm⁻³, the effect of removing surface states formed at the SiC surface regions cannot be obtained. On the other hand, if the amount of at least one of a hydrogen element and a nitrogen element exceeds 10²³ cm⁻³, the film quality of the deposited oxide film 32 cannot be maintained.

The film thickness of the deposited oxide film 32 is preferably 150 nm or more, more preferably 150 to 1000 nm. If the film thickness of the deposited oxide film 32 is less than 150 nm, that is, less than the film thicknesses of electrodes, it is not easy to form electrodes by, for example, a lift-off method. In addition, there is also a case where electrical breakdown of the surface protective film occurs when a high voltage is applied to the semiconductor element. On the other hand, if the film thickness of the deposited oxide film 32 exceeds 1000 nm, the effect obtained by introducing a hydrogen element and/or a nitrogen element is reduced, and in addition, processing time increases, which increases manufacturing costs.

Instead of the NH₃ annealing treatment, any one of the following treatments may be performed: annealing in an atmosphere of NO at normal pressure, annealing in an atmosphere of a mixed gas of NO and N₂ (at normal pressure), annealing in an atmosphere of H₂ at normal pressure, annealing in an atmosphere of NH₃ at normal pressure, and annealing in an atmosphere of a mixed gas of NH₃ and N₂ (at normal pressure).

In the process of formation of emitter electrodes (step S19), emitter electrodes 41 are formed on the surface of the emitter region 14A (low-resistance layer 14) (Fig. 2(e)). The emitter electrodes 41 are formed by vapor deposition or sputtering using nickel or titanium. An electrode pattern is formed by photolithography, dry-etching, wet-etching, or a lift-off method. After the emitter electrodes 41 are formed, heat treatment is performed to reduce contact resistance between the metal and the semiconductor.

In the process of formation of a base electrode and a collector electrode (Step S20), a base electrode 42 is formed on the surface of the base contact region 23 and a collector electrode 43 is formed on the surface of the collector region 10 (substrate 10) (Fig. 2(f)). The collector electrode 43 is formed using nickel or titanium and the base electrode 42 is formed using titanium or aluminum. These electrodes 42 and 43 are formed by vapor deposition or sputtering. An electrode pattern is formed by photolithography, dry-etching, wet-etching, or a lift-off method. After the electrodes 42 and 43 are formed, heat treatment is performed to reduce contact resistance between the metal and the semiconductor.

Finally, the process of formation of an interlayer film and an upper-layer electrode (Step S21) is performed. In the process of formation of an interlayer film and an upper-layer electrode (Step S21), an upper-layer electrode 51 is formed to allow the separated two or more emitter electrodes 41 to function as one electrode (Fig. 2(g)). More specifically, an interlayer 52 such as a silicon dioxide film is formed by CVD, and then the silicon dioxide film formed on the emitter electrodes 41 is removed by photolithography and etching to expose the emitter electrodes 41. Then, the upper-layer electrode 51 is deposited on the emitter electrodes 41 and the interlayer 52. The upper-layer electrode 51 is made of, for example, aluminum (Al).

The semiconductor device and the method for manufacturing the same according to the first embodiment of the present invention can be applied also to a bipolar SIT (Static Induction Transistor) by forming the high-concentration ion implantation region 23 for base contact so that the region 23 is deeper than the channel dope layer 12 as a P-type SiC layer in the step S17 of the method for manufacturing the BJT 100 and by defining the emitter electrodes 41, the base electrode 42, and the collector electrode 43 as source electrodes, a gate electrode, and a drain electrode, respectively.

The current gain of the BJT 100 or SIT according to the first embodiment can be increased by about 20% by the surface protective film 30 composed of the thermal oxide film 31 and the deposited oxide film 32. In this case, the deposited oxide film 32 contains a hydrogen element (hydrogen atoms) in an amount of about 2 × 10¹⁹ cm⁻³ to 3 × 10¹⁹ cm⁻³ and nitrogen element (nitrogen atoms) in an amount of about 1 × 10¹⁸ cm⁻³ to 1 × 10¹⁹ cm⁻³. It has been confirmed that, in this case, the deposited oxide film 32 has a film thickness in the range of 150 to 1000 nm and contains a hydrogen element and a nitrogen element in amounts within the above ranges. It is to be noted that the above-described effect of the surface protective film 30 on an increase in current gain was evaluated by comparison with a comparative standard surface protective film formed by omitting the NH₃ annealing process performed in the first embodiment and by not introducing a hydrogen element and/or a nitrogen element into the deposited oxide film.

### Second Embodiment

Hereinbelow, a second embodiment of the bipolar semiconductor device according to the present invention will be described with reference to Fig. 4. The bipolar semiconductor device according to the second embodiment is represented as a BJT 200. A method for manufacturing the BJT 200 according to the second embodiment is different from the BJT manufacturing method according to the first embodiment only in the details of the process of interface deactivation treatment and formation of surface protective film (step S18), and the other processes (step S11 to step S17 and step S19 to step S21) of the manufacturing method according to the second embodiment are the same as those of the BJT manufacturing method according to the first embodiment.

Fig. 4 is a sectional view showing the structure of the BJT 200 in which the emitter electrodes 41, the base electrode 42, and the collector electrode 43 have already been formed. The second embodiment is the same as the first embodiment in that "(1) deactivation treatment of SiC surface" and "(2) formation of surface protective film and heat treatment" are performed in the step S18. However, in the step S18 of the manufacturing method according to the second embodiment, deposition of SiNx is performed after the deposited oxide film 32 is formed by depositing a PSG film. As a result, a deposited nitride film 33 having a thickness of, for example, 1000 to 2000 Å is formed on the deposited oxide film 32. As described above, in the method for manufacturing the BJT 100 according to the first embodiment, NH₃ annealing treatment is performed after deposition of the PSG film. Also in the case of the second embodiment, NH₃ annealing treatment or the like may be performed before deposition of SiNx as in the case of the first embodiment.

The surface protective film 30 of the BJT 200 according to the second embodiment has a laminated structure composed of the thermal oxide film 31, the deposited oxide film 32, and the deposited nitride film 33. As in the case of the first embodiment, these films are formed on the SiC surface extending from the emitter region 14A except for the emitter electrodes 41 to the base contact region 23 except for the base electrode 42. In this case, the deposited oxide film 32 preferably contains at least one of a hydrogen element and a nitrogen element in an amount of 10¹⁸ to 10²³ cm⁻³, more preferably 10¹⁹ cm⁻³ or more. If the amount of each of a hydrogen element and a nitrogen element contained in the deposited oxide film 32 is less than 10¹⁸ cm⁻³, the effect of removing surface states formed at the SiC surface cannot be obtained. On the other hand, if the amount of at least one of a hydrogen element and a nitrogen element exceeds 10²³ cm⁻³, the film quality of the deposited oxide film 32 cannot be maintained.

The film thickness of the deposited oxide film 32 is preferably 150 to 1000 nm. If the film thickness of the deposited oxide film 32 is less than 150 nm, that is, less than the film thicknesses of electrodes, it is not easy to form electrodes by, for example, a lift-off method. In addition, there is also a case where electrical breakdown of the surface protective film occurs when a high voltage is applied to the semiconductor element. On the other hand, if the film thickness of the deposited oxide film 32 exceeds 1000 nm, the effect obtained by introducing a hydrogen element and/or a nitrogen element is reduced, and in addition, processing time increases, which increases manufacturing costs.

The method for manufacturing the BJT 200 according to the second embodiment can also be applied to a bipolar SIT (Static Induction Transistor) in the same manner as described above with reference to the first embodiment.

The current gain of the BJT 200 or SIT according to the second embodiment can be increased by about 20% by the surface protective film 30 composed of the thermal oxide film 31, the deposited oxide film 32, and the deposited nitride film 33. In this case, the deposited oxide film 32 contains a hydrogen element (hydrogen atoms) in an amount of about 6 × 10¹⁹ cm⁻³ and a nitrogen element (nitrogen atoms) in an amount of about 2 × 10¹⁹ cm⁻³ to 6 × 10¹⁹ cm⁻³. It has been confirmed that, in this case, the deposited oxide film 32 has a thickness in the range of 150 to 1000 nm and contains a hydrogen element and a nitrogen element in amounts within the above ranges. It is to be noted that the above-described effect of the surface protective film on an increase in current gain was evaluated by comparison with a comparative standard surface protective film formed by omitting the NH₃ annealing process performed in the first embodiment and by not introducing a hydrogen element and/or a nitrogen element into the deposited oxide film.

### Third Embodiment

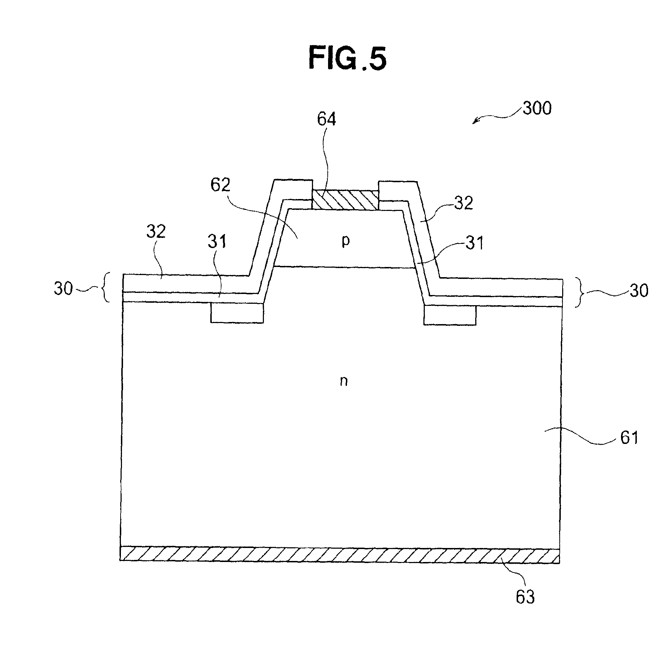

Hereinbelow, a third embodiment of the bipolar semiconductor device according to the present invention will be described with reference to Fig. 5. The bipolar semiconductor device according to the third embodiment is represented as a pn diode 300. Unlike the laminated structure shown in Fig. 2(a), the pn diode 300 has a bilayer laminated structure composed of a cathode region 61 and an anode region 62. The exposed SiC surface of the pn diode 300 is also subjected to the process of interface deactivation treatment and formation of surface protective film. The details of this process are the same as those of the step S18 described above with reference to the first embodiment. The other manufacturing processes are determined (changed) based on the laminated structure of the pn diode. A cathode electrode 63 is formed on the cathode region 61, and anode electrodes 64 are formed on the anode region 62. As shown in Fig. 5, as in the case of the first embodiment, the surface protective film 30 having a laminated structure composed of the thermal oxide film 31 and the deposited oxide film 32 is formed on the SiC surface extending from the anode region 62 except for the anode electrodes 64 to the cathode region 61, that is, on the SiC surface between the adjacent anode electrodes 64 (or between adjacent regions forming the anode region 62). The surface protective film formed in the third embodiment has the same effect as that formed in the first embodiment. The thermal oxide film 31 and the deposited oxide film 32 are formed in the same manner as in the first embodiment.

The surface recombination current of the pn diode 300 according to the third embodiment can be improved by about 20% by the surface protective film 30 composed of the thermal oxide film 31 and the deposited oxide film 32, and therefore a leak current can be suppressed. In this case, the deposited oxide film 32 contains a hydrogen element (hydrogen atoms) in an amount of about 2 × 10¹⁹ to 3 × 10¹⁹ cm⁻³ and a nitrogen element (nitrogen atoms) in an amount of about 1 × 10¹⁸ to 1 × 10¹⁹ cm⁻³. It has been confirmed that, in this case, the deposited oxide film 32 has a film thickness in the range of 150 to 1000 nm and contains a hydrogen element and a nitrogen element in amounts within the above ranges. It is to be noted that the above-described effect of the surface protective film 30 on an increase in current gain was evaluated by comparison with a comparative standard surface protective film formed by omitting the NH₃ annealing process performed in the third embodiment and by not introducing a hydrogen element and/or a nitrogen element into the deposited oxide film.

### Fourth Embodiment

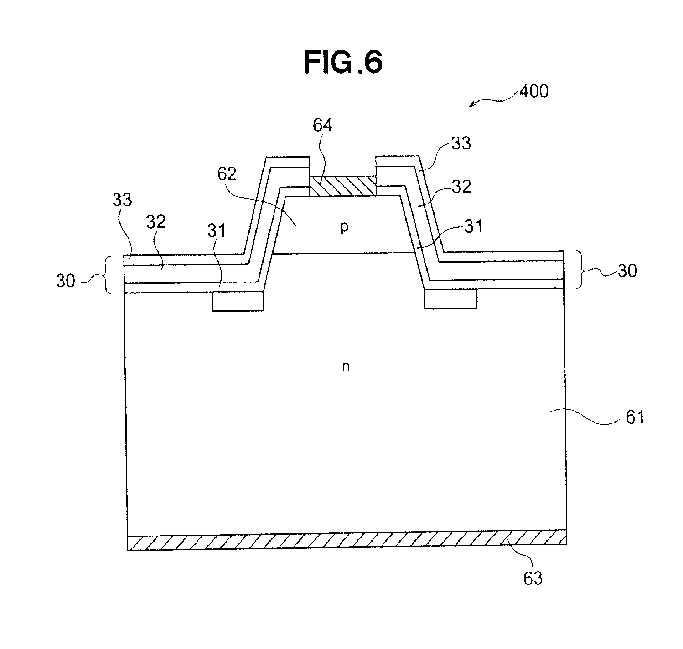

Hereinbelow, a fourth embodiment of the bipolar semiconductor device according to the present invention will be described with reference to Fig. 6. The bipolar semiconductor device according to the fourth embodiment is represented as a pn diode 400. As in the case of the third embodiment, the pn diode 400 has a bilayer laminated structure composed of the cathode region 61 and the anode region 62. However, the pn diode according to the fourth embodiment is different from the pn diode according to the third embodiment in that, as in the case of the second embodiment, the surface protective film 30 has a laminated structure composed of the thermal oxide film 31, the deposited oxide film 32, and the deposited nitride film 33. The SiC surface of the pn diode 400 according to the fourth embodiment is also subjected to the process of interface deactivation treatment and formation of surface protective film as in the case of the second embodiment. The details of this process are the same as those of the step S18 described above with reference to the second embodiment. The details of the other manufacturing processes are determined based on the laminated structure of the pn diode. The pn diode 400 shown in Fig. 6 has the same structure as the pn diode 300 shown in Fig. 5 except for the surface protective film 30. As shown in Fig. 6, as in the case of the second embodiment, the surface protective film 30 having a laminated structure composed of the thermal oxide film 31, the deposited oxide film 32, and the deposited nitride film 33 is formed on the SiC surface extending from the anode region 62 except for the anode electrodes 64 to the cathode region 61, that is, on the SiC surface between the adjacent anode electrodes 64 (or between the adjacent anode regions 62). The thermal oxide film 31, the deposited oxide film 32, and the deposited nitride film 33 are formed in the same manner as described above with reference to the second embodiment.

The surface recombination current of the pn diode 400 according to the fourth embodiment can be improved by about 20% by the surface protective film 30 composed of the thermal oxide film 31, the deposited oxide film 32, and the deposited nitride film 33, and therefore a leak current can be suppressed. The deposited oxide film 32 contains a hydrogen element (hydrogen atoms) in an amount of about 6 × 10¹⁹ cm⁻³ and a nitrogen element (nitrogen atoms) in an amount of about 2 × 10¹⁹ to 6 × 10¹⁹ cm⁻³. It has been confirmed that, in this case, the deposited oxide film 32 has a film thickness in the range of 150 to 1000 nm and contains a hydrogen element and a nitrogen element in amounts within the above ranges. It is to be noted that the above-described effect of the surface protective film 30 on an increase in current gain was evaluated by comparison with a comparative standard surface protective film formed by omitting the process of forming a deposited nitride film performed in the fourth embodiment and by not introducing a hydrogen element and/or a nitrogen element into the deposited oxide film.

It is to be noted that the structures, shapes, sizes, and positional relationships of the structural components of the semiconductor devices according to the above embodiments have been roughly described above only to such an extent that the present invention can be understood or carried out and the values and the compositions (materials) of the structural components are merely illustrative. Therefore, the present invention is not limited to the above embodiments and various modifications may be made thereto without departing from the technical scope defined by the claims.

### INDUSTRIAL APPLICABILITY

According to the present invention, it is possible to increase the current gain of a bipolar SiC semiconductor device by forming a surface protective film containing predetermined concentrations of a hydrogen element and a nitrogen element so that surface states formed at the surface of the bipolar SiC semiconductor device are removed.

### LEGEND

- 10: substrate
- 11: high-resistance layer
- 12: channel dope layer
- 13: base region
- 14: low-resistance layer
- 14A: emitter region
- 21: silicon oxide film
- 23: base contact region
- 30: surface protective film
- 31: thermal oxide film
- 32: deposited oxide film
- 33: deposited nitride film
- 41: emitter electrode
- 42: base electrode
- 43: collector electrode
- 51: upper-layer electrode
- 52: interlayer film
- 61: cathode region
- 62: anode region
- 100: bipolar semiconductor device (BJT)
- 200: BJT
- 300: pn diode
- 400: pn diode

## Claims

1. A bipolar semiconductor device comprising:
a semiconductor element having a surface; and
a surface protective film provided on the surface of the semiconductor element,
wherein the surface protective film has a laminated structure composed of a thermal oxide film formed on the surface of the semiconductor element and a deposited oxide film formed on the thermal oxide film, and the deposited oxide film contains at least one of a hydrogen element and a nitrogen element in an amount of 10¹⁸ cm⁻³ or more.

2. The bipolar semiconductor device according to claim 1, wherein the deposited oxide film has a film thickness of 150 nm or more.

3. The bipolar semiconductor device according to claim 1, wherein the semiconductor element is a silicon carbide semiconductor element and includes a collector region composed of an n-type low-resistance layer formed on one of surfaces of a silicon carbide semiconductor crystal, an emitter region composed of an n-type low-resistance layer formed on another surface of the silicon carbide semiconductor crystal, a p-type base contact region formed around the emitter region, and a base region and an n-type high-resistance layer provided between the emitter region and the collector region, wherein the surface protective film is formed on the surface of the silicon carbide semiconductor element in the base region and the emitter region.

4. The bipolar semiconductor device according to claim 1, wherein the semiconductor element is a silicon carbide semiconductor element and includes a drain region composed of an n-type low-resistance layer formed on one of surfaces of a silicon carbide semiconductor crystal, a source region composed of an n-type low-resistance layer formed on another surface of the silicon carbide semiconductor crystal, a p-type gate region formed around the source region, and an n-type high-resistance layer provided between the source region and the drain region, and wherein the surface protective film is formed on the surface of the silicon carbide semiconductor element in the gate region and the source region.

5. The bipolar semiconductor device according to claim 1 wherein the semiconductor element is a silicon carbide semiconductor element and includes a cathode region composed of an n-type resistance layer formed on one of surfaces of a silicon carbide semiconductor crystal and an anode region composed of a p-type resistance layer formed on another surface of the silicon carbide semiconductor crystal, and wherein an anode electrode is formed on the anode region and the surface protective film is formed on the surface of the silicon carbide semiconductor element except for the anode electrode.

6. The bipolar semiconductor device according to claim 3, further comprising a p-type channel dope layer provided in the high-resistance layer, the p-type channel dope layer being connected to the base contact region.

7. A bipolar semiconductor device comprising:
a semiconductor element having a surface; and
a surface protective film provided on the surface of the semiconductor element,
wherein the surface protective film has a laminated structure composed of a thermal oxide film formed on the surface of the semiconductor element, a deposited oxide film formed on the thermal oxide film, and a deposited nitride film formed on the deposited oxide film, and the deposited oxide film contains at least one of a hydrogen element and a nitrogen element in an amount of 10¹⁹ cm⁻³ or more.

8. The bipolar semiconductor device according to claim 7, wherein the deposited oxide film has a film thickness of 150 nm or more.

9. The bipolar semiconductor device according to claim 7, wherein the semiconductor element is a silicon carbide semiconductor element and includes a collector region composed of an n-type low-resistance layer formed on one of surfaces of a silicon carbide semiconductor crystal, an emitter region composed of an n-type low-resistance layer formed on another surface of the silicon carbide semiconductor crystal, a p-type base contact region formed around the emitter region, and a base region and an n-type high-resistance layer provided between the emitter region and the collector region, and wherein the surface protective film is formed on the surface of the silicon carbide semiconductor element in the base region and the emitter region.

10. The bipolar semiconductor device according to claim 7, wherein the semiconductor element is a silicon carbide semiconductor element and includes a drain region composed of an n-type low-resistance layer formed on one of surfaces of a silicon carbide semiconductor crystal, a source region composed of an n-type low-resistance layer formed on another surface of the silicon carbide semiconductor crystal, a p-type gate region formed around the source region, and an n-type high-resistance layer provided between the source region and the drain region, and wherein the surface protective film is formed on the surface of the silicon carbide semiconductor element in the gate region and the source region.

11. The bipolar semiconductor device according to claim 7 wherein the semiconductor element is a silicon carbide semiconductor element and includes a cathode region composed of an n-type resistance layer formed on one of surfaces of a silicon carbide semiconductor crystal and an anode region composed of a p-type resistance layer formed on another surface of the silicon carbide semiconductor crystal, and wherein an anode electrode is formed on the anode region and the surface protective film is formed on the surface of the silicon carbide semiconductor element except for the anode electrode.

12. The bipolar semiconductor device according to claim 9, further comprising a p-type channel dope layer provided in the high-resistance layer, the p-type channel dope layer being connected to the base contact region.

13. A method for manufacturing a bipolar semiconductor device comprising a silicon carbide semiconductor element having a surface and a surface protective film provided on the surface of the silicon carbide semiconductor element, the method comprising the steps of:
forming a thermal oxide film on the surface of the silicon carbide semiconductor element; and
forming a deposited oxide film on the thermal oxide film, wherein the surface protective film is composed of the thermal oxide film and the deposited oxide film, and wherein the deposited oxide film contains at least one of a hydrogen element and a nitrogen element in an amount of 10¹⁸ cm⁻³ or more.

14. The method for manufacturing a bipolar semiconductor device according to claim 13, wherein the deposited oxide film has a film thickness of 150 nm or more.

15. A method for manufacturing a bipolar semiconductor device comprising a silicon carbide semiconductor element having a surface and a surface protective film provided on the surface of the silicon carbide semiconductor element, the method comprising the steps of:
forming a thermal oxide film on the surface of the silicon carbide semiconductor element;
forming a deposited oxide film on the thermal oxide film; and
forming a deposited nitride film on the deposited oxide film, wherein the surface protective film is composed of the thermal oxide film, the deposited oxide film, and the deposited nitride film, and wherein the deposited oxide film contains at least one of a hydrogen element and a nitrogen element in an amount of 10¹⁹ cm⁻³ or more.

16. The method for manufacturing a bipolar semiconductor device according to claim 15, wherein the deposited oxide film has a film thickness of 150 nm or more.
